Europäisches Patentamt

European Patent Office

Office européen des brevets

(11) Numéro de publication : **0 543 703 B1**

(12) **FASCICULE DE BREVET EUROPEEN**

(19)

(45) Date de publication du fascicule du brevet :
**19.10.94 Bulletin 94/42**

(51) Int. Cl.⁵ : **G11C 16/04, H01L 29/52**

(21) Numéro de dépôt : **92403039.8**

(22) Date de dépôt : **10.11.92**

(54) **Mémoire intégrée électriquement programmable à un seul transistor.**

(30) Priorité : **13.11.91 FR 9113946**

(43) Date de publication de la demande :
**26.05.93 Bulletin 93/21**

(45) Mention de la délivrance du brevet :
**19.10.94 Bulletin 94/42**

(84) Etats contractants désignés :
**DE FR GB IT**

(56) Documents cités :
**EP-A- 0 183 235**
**EP-A- 0 443 515**
**GB-A- 2 073 484**
**GB-A- 2 077 492**

(73) Titulaire : **SGS-THOMSON**
**MICROELECTRONICS S.A.**
**7, Avenue Galliéni**
**F-94250 Gentilly (FR)**

(72) Inventeur : **Devin, Jean**
**CABINET BALLOT-SCHMIT,**
**7, Rue le Sueur**
**F-75116 Paris (FR)**

(74) Mandataire : **Schmit, Christian Norbert Marie**
**et al**
**Cabinet Ballot-Schmit**
**7, rue Le Sueur**
**F-75116 Paris (FR)**

## Description

L'invention concerne les mémoires en circuit intégré, et plus particulièrement les mémoires non volatiles qui utilisent comme cellule élémentaire de stockage d'information un transistor à grille flottante.

Dans ces mémoires, une grille flottante recouvre un canal de transistor à effet de champ, et une grille de commande recouvre la grille flottante. La grille flottante est isolée de la grille de commande et du canal par des couches minces isolantes. La programmation électrique et l'effacement électrique de la mémoire consistent en une injection et une évacuation d'électrons hors de la grille flottante à travers l'isolant. Selon la quantité de charges piégées dans la grille flottante, la tension de lecture minimale qu'il faut appliquer à la grille de commande pour rendre le transistor conducteur (ou inversement pour le bloquer) est plus ou moins importante. Avec une tension de lecture fixe appliquée à la grille flottante on peut donc déterminer quel est l'état (programmé ou non) du transistor. Cet état représente l'information binaire stockée dans le transistor.

Pour constituer des mémoires capables de stocker une certaine quantité d'information, on dispose ces cellules en réseaux matriciels : les cellules sont disposées en lignes et colonnes. Toutes les cellules d'une même ligne sont raccordées à un même conducteur de ligne (appelé généralement ligne de mot) et toutes les cellules d'une même colonne sont raccordées à un même conducteur de colonne (appelé généralement ligne de bit). La ligne de mot sert à désigner les cellules d'une ligne déterminée. La ligne de bit sert à lire ou écrire une information dans la cellule qui est située au carrefour de cette ligne de bit et de la ligne de mot désignée.

Pour que les cellules puissent ainsi être organisées en réseau matriciel, il faut qu'il existe une possibilité d'effectuer une opération sur une cellule déterminée sans affecter les cellules non désignées. Cela veut dire qu'il faut pouvoir appliquer des potentiels déterminés à une seule cellule, à travers la ligne de bit et la ligne de mot qui se croisent à l'emplacement de cette cellule, sans que les potentiels ainsi appliqués aux autres cellules de la même ligne de mot ou de la même ligne de bit affectent ces autres cellules. Si ce n'était pas le cas on ne pourrait pas accéder individuellement aux informations contenues dans les différentes cellules.

Dans la technique industrielle actuelle, on utilise deux grands principes pour réaliser des mémoires à grille flottante programmables et effaçables électriquement, capables d'être organisées en réseau matriciel et d'être sélectionnées individuellement dans ce réseau.

Le premier principe est celui des mémoires EEPROM (de l'anglais "Electrically Programmable and Erasable Memory"). Ces mémoires sont programmées et effacées par application d'un champ électrique à travers un oxyde très mince séparant la grille flottante du canal. Les charges électriques passent à travers la couche isolante par effet Fowler-Nordheim. Le transistor n'est pas conducteur pendant la programmation ou l'effacement. Le sens de passage des charges (effacement ou programmation) est défini par le sens du champ appliqué. Le champ est appliqué en portant la grille de commande à un potentiel élevé (de l'ordre de 20 volts) et le drain à la masse, ou le contraire. La source est à la masse pour l'injection d'électrons dans la grille flottante, et elle est en haute impédance pour l'extraction d'électrons.

Si on se contentait de ce transistor comme cellule mémoire, il serait impossible d'organiser un réseau matriciel de cellules programmables et effaçables individuellement. Car on ne pourrait pas appliquer les tensions de programmation ou d'effacement au drain ou à la grille flottante à travers une ligne de bit ou une ligne de mot raccordée à d'autres cellules sans programmer ou effacer en même temps d'autres cellules.

C'est pourquoi, pour les mémoires EEPROM classiques, on utilise comme cellule l'ensemble en série d'un transistor à grille flottante et d'un transistor de sélection. C'est le transistor de sélection qui a sa grille commandée par la ligne de mot et non pas le transistor à grille flottante. Dans ces conditions il devient possible de sélectionner la lecture ou l'écriture d'un transistor à grille flottante en désélectionnant les autres cellules; la mise en conduction du transistor de sélection autorise l'application d'une tension de drain déterminée aux transistors de toute une ligne, mais on n'applique une tension de drain ou grille de commande élevée qu'à la colonne désirée.

L'autre catégorie de cellules mémoires utilisées industriellement et organisables en réseau matriciel est la catégorie des "EPROM!". Le transistor à grille flottante est utilisé seul, sans transistor de sélection. Mais la programmation est effectuée par effet dit de "porteurs chauds", c'est-à-dire qu'il ne suffit pas d'appliquer un champ électrique important du canal vers la grille flottante pour que les électrons passent, il faut en outre que ces électrons soient au préalable accélérés dans le canal conducteur pour acquérir une énergie suffisante. La programmation s'effectue donc en appliquant une tension élevée simultanément au drain et à la grille de commande, la source étant à la masse. Les transistors des autres lignes, qui n'ont pas une tension élevée sur leur grille, et les transistors des autres colonnes, qui n'ont pas une tension élevée sur leur drain, ne sont pas programmés; et ils ne sont pas effacés non plus.

Pour l'effacement, dans le cas des mémoires dites "flash EPROM", on applique des impulsions de tension élevée positive sur le drain ou sur la source en maintenant la grille de commande à la masse. Mais l'effacement est global : on ne peut pas accéder individuellement aux différentes cellules. On peut à la rigueur diviser la mémoire en secteurs effaçables séparément.

Les EPROM et les EEPROM souffrent chacune d'inconvénients qu'il serait souhaitable d'éliminer ou de réduire.

Les EPROM consomment beaucoup de courant à la programmation, à cause de la nécessité de rendre conducteurs les transistors sous des tensions élevées. Il faut à la fois une tension élevée (7 à 15 volts) et un courant important (l'ordre de grandeur est le milliampère par cellule). La tension importante peut être amenée de l'extérieur mais cela oblige l'utilisateur de la mémoire à prévoir cette alimentation en plus de l'alimentation classique à faible tension nécessaire au fonctionnement en dehors de la phase de programmation. Ou alors la tension élevée est produite par une pompe de charge interne au circuit intégré. Mais on ne sait pas faire facilement une pompe de charge produisant à la fois une tension importante et un courant important. Et de toutes façons on ne peut programmer qu'un petit nombre de cellules à la fois si on ne veut pas atteindre des courants destructeurs. Cela peut poser un problème important lors du test des mémoires car le fabricant ne peut pas se permettre de consacrer un temps de test trop important à chaque circuit. Enfin, les mémoires EPROM présentent l'inconvénient de nécessiter un cycle de programmation en deux temps : on ne peut pas programmer un mot d'information sans avoir au préalable effacé globalement la mémoire puisqu'on ne sait pas effacer individuellement une cellule.

Les cellules EEPROM quant à elles ne présentent aucun de ces inconvénients. Mais elles sont plus encombrantes à cause du transistor de sélection qui leur est nécessairement associé dès lors qu'elles sont agencées en réseau matriciel.

Le document EP-A- 0 443 515 décrit une cellule mémoire comprenant un transistor à grille flottante. Ce transistor comporte une grille d'effacement connecté à la source ou au drain du transistor et recouvrant complètement la grille flottante. Cette grille d'effacement qui est commune à un groupe de cellules mémoires permet l'effacement simultané de ce groupe de cellules par évacuation d'électrons des grilles flottantes des cellules vers la grille d'effacement.

Un but de l'invention est de proposer un nouveau type de cellule de mémoire qui évite le mieux possible les inconvénients des cellules de l'art antérieur.

Selon l'invention on propose une cellule de mémoire comportant un transistor à grille flottante ayant une source, un drain, une grille flottante et une grille de commande, caractérisée en ce qu'elle comporte des moyens pour établir un fort couplage capacitif entre le drain et la grille flottante.

Selon l'invention, le couplage capacitif entre drain et grille flottante est choisi suffisamment élevé, en application des explications qui seront données dans la suite, pour qu'il soit possible de programmer individuellement les cellules sans faire appel à une injection par porteurs chauds, et ceci même lorsque les cellules sont organisées en réseau matriciel avec les grilles des transistors d'une même ligne toutes raccordées ensemble et les drains des transistors d'une même colonne tous raccordés ensemble.

Par conséquent, selon l'invention, grâce à un couplage capacitif drain-grille flottante beaucoup plus élevé que pour les mémoires EEPROM et EPROM utilisées industriellement, on montrera qu'il est possible de programmer les cellules selon le même principe que les EEPROM, c'est-à-dire sans la consommation de courant élevée des EPROM et flash EPROM, et sans qu'on ait besoin d'un transistor de sélection pour l'organisation en réseau matriciel.

Le couplage capacitif peut être élevé selon deux critères possibles, éventuellement mesurés simultanément : d'une part il peut être élevé par rapport au couplage capacitif entre source et grille flottante (de préférence environ deux fois supérieur au moins); mais il peut aussi être important par rapport au couplage capacitif entre grille de commande et grille flottante, c'est-à-dire au moins égal ou presque égal à ce dernier, alors que dans l'art antérieur le couplage entre grille de commande et grille flottante est de loin le plus important.

De préférence, le couplage capacitif accru est réalisé grâce à une couche conductrice ou une couche semi-conductrice en contact avec le drain et recouvrant en partie la grille flottante à un endroit ou celle-ci n'est pas recouverte par la grille de commande. Mais d'autres dispositions pourraient être envisagées, par exemple avec une grille flottante qui recouvre une partie du drain.

Dans une technologie à deux niveaux de silicium poly-cristallin, la grille flottante est réalisée à l'aide du premier niveau; la grille de commande et une portion de couche reliée au drain sont réalisées à l'aide du deuxième niveau au dessus de la grille flottante.

D'autres caractéristiques et avantages de l'invention apparaîtront à la lecture de la description détaillée qui suit et qui est faite en référence aux dessins annexés dans lesquels :

- la figure 1 représente le principe général de l'invention;
- la figure 2 représente en coupe transversale un exemple concret de réalisation;
- la figure 3 représente en vue de dessus la configuration de la cellule de la figure 2.

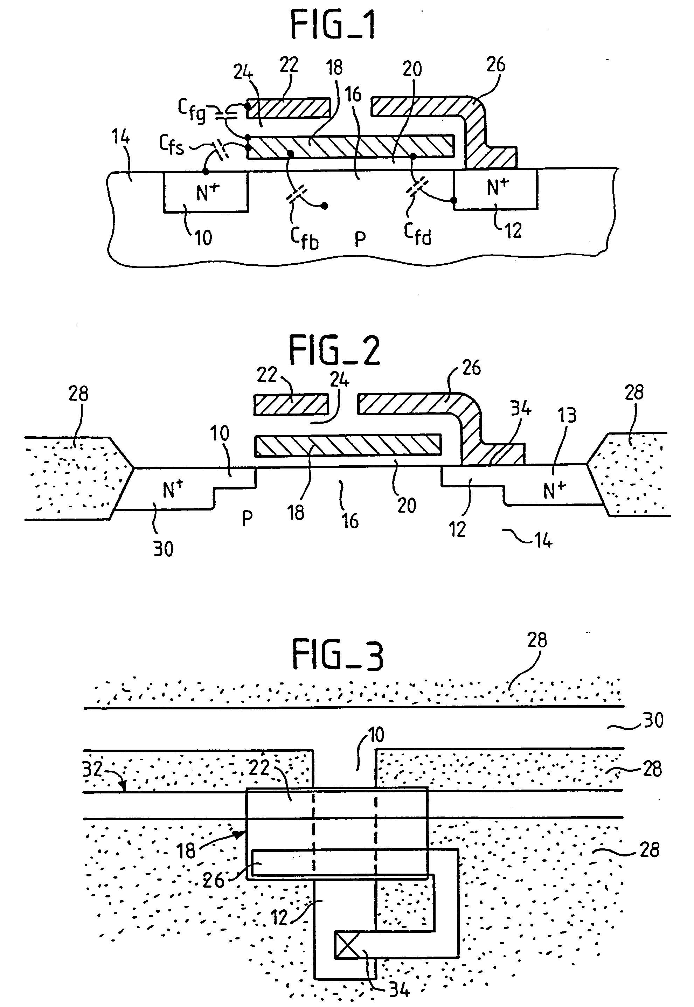

Le principe de la cellule de mémoire selon l'invention est schématisé à la figure 1.

La cellule comporte un seul transistor, c'est-à-dire un seul canal entre une région de source 10 et une région de drain 12. La source et le drain sont réalisées par exemple par des diffusions de type N dans un substrat conducteur 4 de type P. La partie superficielle du substrat entre la source 10 et le drain 12 constitue alors le canal 16 du transistor.

Le transistor est un transistor à grille flottante; le canal 16 est entièrement recouvert par une grille flottante 18, qui est séparée du canal par une couche isolante 20 très mince.

Une grille de commande 22 recouvre au moins partiellement la grille flottante et en est séparée par une mince couche isolante 24.

Dans les transistors EEPROM ou EPROM classiques, on s'arrange en général pour que le couplage capacitif entre la grille flottante et la source, et le couplage capacitif entre la grille flottante et le drain, soient faibles par rapport au couplage capacitif entre la grille flottante et la grille de commande. Pour cela, on s'arrange d'habitude d'une part pour que la grille de commande recouvre totalement la grille flottante (couplage maximal) et d'autre part pour que les bords de la grille flottante soient auto-alignés avec les bords des régions de source et drain afin qu'il y ait un recouvrement minimal de la source et du drain par la grille flottante (couplage minimal). Bien entendu le couplage a quand même une valeur non négligeable car on ne peut pas écarter le drain de la grille flottante puisque l'injection d'électrons dans la grille flottante doit se faire à travers un intervalle isolant très mince entre drain et grille flottante.

Selon l'invention on propose d'établir volontairement un couplage capacitif important entre la grille flottante et le drain. Par contre on conserve un couplage faible entre la grille flottante et la source.

Dans l'exemple représenté, ce couplage capacitif important est obtenu par une portion de couche conductrice 26 recouvrant une partie de la grille flottante 18 à un endroit de cette dernière qui n'est pas recouvert par la grille de commande 22. Cette couche conductrice 26 est séparée de la grille flottante par une couche isolante mince, de préférence une portion de la couche 24 qui recouvre la grille flottante.

La grille flottante est par définition isolée de tout autre point pour ce qui est des courants continus, à l'exception du courant très faible qui circule pendant une opération de programmation ou d'effacement. Par conséquent, on peut en général calculer le potentiel de la grille flottante simplement à partir des couplages capacitifs qui existent entre cette grille et les zones voisines qui sont portées à des potentiels variables par les circuits de commande du transistor.

La grille flottante est entourée par la source, le drain, la grille de commande, et le substrat. Il y a une capacité naturelle entre la grille et chacune de ces zones. La somme de toutes ces capacités est considérée arbitrairement comme ayant une valeur unité. Autrement dit, on va supposer que les capacités mentionnées sont mesurées en unités correspondant à la somme des valeurs des capacités reliant la grille flottante à d'autres points. On appellera indifféremment "capacité" ou "couplage capacitif" entre la grille flottante et un point donné la valeur de la capacité existant entre cette grille et ce point, mesurée dans cette unité particulière.

Si on appelle Cdf la capacité entre drain et grille flottante, Csf la capacité entre source et grille flottante, Cgf la capacité entre grille de commande et grille flottante, et Cbf la capacité entre le substrat et la grille flottante,
avec Cdf + Csf + Cgf + Cbf = 1 unité capacitive
on peut calculer la tension présente sur la grille flottante en fonction des tensions de drain (Vd), de source (Vs), de grille de commande (Vg), et de substrat (Vb).

En effet, la tension Vf de la grille flottante est la somme de ces diverses tensions pondérées par les différents couplages capacitifs respectifs.

$$Vf = (Cdf.Vd + Csf.Vs + Cgf.Vg + Cbf.Vb) / 1 \text{ unité capacitive}$$

On comprendra que cette explication est simplifiée; en effet, la tension de substrat au dessous de la grille flottante n'est pas uniforme et il faudrait en fait décomposer le canal en petites portions portées à des potentiels déterminés et tenir compte du couplage capacitif de chacune de ces portions. L'invention sera cependant mieux comprise avec l'explication simplifiée; on pourra toujours faire appel à des outils de simulation pour affiner les calculs dans l'élaboration d'une structure concrète.

Par ailleurs, pour pouvoir donner un exemple pratique du principe de l'invention sans entrer dans des calculs complexes, on va également supposer que le couplage capacitif entre grille et substrat est faible devant la somme des couplages capacitifs avec la source, le drain et la grille de commande.

On fera donc l'hypothèse simplificatrice suivante :

$$Vf = Cdf.Vd + Csf.Vs + Cgf.Vg \quad (1)$$

Enfin, si la cellule est programmée, une charge Q est stockée sur la grille flottante, et modifie l'équation de la manière suivante :

$$Vf = Cdf.Vd + Csf.Vs + Cgf.Vg + Q \quad (2)$$

(l'absence d'homogénéité apparente de cette équation résulte évidement du fait que la somme des capacités est égale à l'unité)

Q représente alors le potentiel que prend la grille flottante si les autres électrodes sont à zéro. Q représente aussi la tension qu'il faut additionner au potentiel de la grille flottante si on calcule ce potentiel par l'équation 1 dans le cas d'une cellule programmée. En pratique Q est négatif et on doit soustraire une valeur de un ou plusieurs volts au potentiel calculé par l'équation 1.

A titre d'exemple numérique pour la démonstration, on supposera que les couplages capacitifs sont les suivants :

Cdf = 0,5
Csf = 0,25
Cgf = 0,25

On voit donc qu'on a choisi un fort couplage capacitif drain/grille flottante puisqu'il est plus élevé que le couplage entre grille de commande et grille flottante, ce qui n'est pas le cas dans les EPROM et EEPROM classiques où le couplage entre les deux grilles serait plutôt de l'ordre de 0,7 et le couplage avec le drain ou la source de l'ordre de 0,1 à 0,2.

Pour conserver des valeurs usuelles de tensions de programmation, d'effacement et de lecture, on va supposer que :

1./ En programmation, la tension de drain est de 10 volts, la tension de grille de commande est de 12 volts, et la source est en haute impédance; cependant la source peut être considérée comme fortement couplée capacitivement à la masse de sorte qu'en pratique son potentiel peut être considéré comme très proche de zéro.

2./ En effacement, le drain est en haute impédance mais également considéré comme couplé fortement capacitivement à la masse et donc de potentiel voisin de zéro, la grille de commande est à la masse, et la source est à 10 volts. L'effacement peut être réalisé par applications d'une succession d'impulsions de tension abruptes sur la source.

3./ En lecture, le drain est porté à environ 2 volts, la grille de commande est à 5 volts, et la source est à la masse.

Ces valeurs ne sont donnés qu'à titre d'exemple pour la compréhension de l'invention.

Pour que la mémoire puisse fonctionner en réseau, avec des cellules programmables et lisibles individuellement, il faut que ces tensions puissent être appliquées sur des conducteurs de ligne et de colonne d'une manière telle que la programmation s'effectue sur une seule cellule (au croisement d'une ligne et d'une colonne) sans perturber les autres. De même pour la lecture. Pour l'effacement, il n'est pas indispensable que les cellules soient effacées individuellement.

On va donc placer les cellules en réseau avec des conducteurs de ligne (lignes de mot) reliant chacun les grilles de commande de tous les transistors situés sur une même ligne et des conducteurs de colonne (lignes de bit) reliant chacun les drains de tous les transistors situés sur une même colonne (disposition classique pour une mémoire EPROM).

Pour que le fonctionnement souhaité soit possible il faut que la programmation s'effectue pour la cellule qui a sa ligne de mot à 12 volts et sa ligne de bit à 10 volts; et il faut pouvoir appliquer aux autres lignes de mot des tensions telles que les autres cellules de la même ligne de bit ne soient pas programmées; et enfin il faut pouvoir appliquer aux autres lignes de bit des tensions telles que les cellules de la même ligne de mot ne soient pas programmées. A priori, les lignes de mot non sélectionnées seront portées à la masse, de même que les lignes de bit non sélectionnées.

Dans l'exemple numérique choisi, on considère qu'il y a programmation de la cellule par injection d'électrons dans la grille flottante dès lors qu'il y a une tension électrique de plus de 7 volts entre cette grille et la source ou le drain. Et on considère qu'il n'y a pas programmation au dessous de 7 volts. Ceci est assez réaliste pour une injection d'électrons à travers une couche d'oxyde silicium d'une centaine d'angströms d'épaisseur. Réciproquement, on considère qu'il y a effacement à partir de 7 volts dans l'autre sens. Il n'y a pas effacement ou programmation par injection ou évacuation d'électrons entre la grille flottante et la grille de commande, même pour une tension supérieure à 7 volts, car la couche isolante 24 est plus épaisse que la couche 20. Ces valeurs sont données à titre d'exemple pour faire comprendre l'invention.

## 1. PROGRAMMATION

Il faut donc calculer la tension Vf de la grille flottante d'après la formule précédemment indiquée, à partir des couplages capacitifs et des tensions de drain (Vd), source (Vs) et grille de commande (Vg), aussi bien pour une cellule sélectionnée (pour vérifier qu'elle va se programmer) que pour des cellules non sélectionnées (pour vérifier qu'elles ne vont pas se programmer ni s'effacer).

1.a./ Cellule sélectionnée

Vd = 10 volts     Vs = 0 volt     Vg = 12 volts

D'où Vf = O,5.Vd + 0,25.Vs + 0,25.Vg avec les valeurs de couplages capacitifs choisies, c'est-à-dire Vf = 8 volts;

la présence d'une tension de 8 volts entre source et grille flottante provoque l'injection d'électrons entre le bord de la source et le bord de la grille flottante. La cellule sélectionnée est programmée.

1.b./ cellule totalement désélectionnée : ce sont les cellules qui ne sont pas situées sur la même ligne de bit ni sur la même ligne de mot.

Ces cellules ont donc à la fois leur drain et leur grille de commande à la masse et leur source en haute impédance; leur grille flottante reste à zéro volt; elles ne risquent pas d'être programmées.

1.c./ Cellule désélectionnée seulement par la grille de commande : ce sont les cellules situées sur la même ligne de bit (drain à 10 volts) mais pas sur la même ligne de mot (grille de commande à 0 volt).

Vd = 10 v     Vs = 0     Vg = 0

D'où Vf = 5 volts.

La tension maximale entre la grille et un autre point est au maximum de 5 volts. Il n'y a pas programmation.

1.d./ Cellule désélectionnée seulement par le drain : ce sont les cellules qui sont sur la même ligne de mot (grille à 12 volts) mais pas sur la même ligne de bit (drain à 0 volt).

     $V_d = 0$ v      $V_s = 0$      $V_g = 12$ v

     D'où $V_f = 3$ volts.

La tension maximale présente entre la grille flottante et le drain ou la source n'est que de 3 volts. Il n'y a pas programmation.

On peut vérifier par ailleurs que si la cellule a été programmée auparavant, une tentative de programmation d'autres cellules ne va pas l'effacer. Pour cela on peut recalculer les valeurs de tension et de différences de potentiel ci-dessus en soustrayant par exemple 1,5 Volt à $V_f$, ce qui représente une évaluation réaliste de la composante de potentiel négatif Q intrinsèquement due à la charge négative stockée sur la grille flottante (voir formule (2) plus haut). On vérifie qu'il n'y a pas de problème.

## 2. EFFACEMENT

Le raisonnement fait ci-dessus pour la programmation d'une cellule sélectionnée peut être fait également pour l'effacement d'une cellule.

2.a./ Cellule sélectionnée

     $V_d = 0$      $V_s = 10$ volts      $V_g = 0$

     D'où $V_f = 2,5$ volts

Il y a 7,5 volts entre source et grille flottante dans un sens tendant à l'effacement. La tension de source peut être appliquée sous forme d'impulsions répétées. La cellule est effacée.

2.b./ Cellule désélectionnée par la grille

Si on porte les lignes de mot non sélectionnées à 12 volts, on va empêcher l'effacement des cellules de ces lignes; en effet :

     $V_d = 0$      $V_s = 10$ volts      $V_g = 12$ volts

     D'où $V_f = 5,5$ volts.

     la tension maximale est de 5,5 volts entre grille flottante et drain, dans un sens tendant à l'effacement mais insuffisante pour réaliser l'effacement.

2.c./ Cellule désélectionnée par le drain

On ne peut pas désélectionner les cellules en appliquant une tension sur le drain des colonnes non sélectionnées : il y aurait risque de programmation des cellules de ces colonnes (celles qui sont sur la ligne de mot sélectionnée) si la tension sur le drain est la même que la tension de source, et il y aurait mise en conduction des transistors de presque tout le plan mémoire si la tension de drain est différente de la tension de source. Il est nécessaire de laisser le drain en haute impédance.

Cela veut dire que l'effacement peut être effectué ligne par ligne, ce qui est tout-à-fait intéressant (l'effacement dans les flash EPROM ne peut se faire que globalement ou par secteurs entiers du plan mémoire). Les lignes qu'on ne veut pas effacer sont portées à 10 ou 12 volts par exemple.

On peut toutefois ici aussi choisir d'effectuer un effacement global ou par secteur, en appliquant 10 volts sur la source de tout un secteur et en mettant à 0 volt toutes les lignes de mot du plan mémoire. Comme dans les flash EPROM, l'effacement par secteur n'est possible bien entendu que si les sources de transistors correspondant à un secteur déterminé sont isolées de celles des autres secteurs.

## 3. LECTURE

Il faut encore pouvoir vérifier qu'on peut lire les cellules individuellement. Pour cela on suppose que le seuil de tension VT1 à appliquer à la grille flottante pour que le transistor soit rendu conducteur est d'environ VT1 = 2 volts. On suppose aussi que la composante de potentiel induite sur la grille flottante du fait de la charge négative de celle-ci lorsqu'elle est programmée est Q = -1,5 volts; voir formule (2) plus haut.

On porte la ligne de mot à 5 volts ($V_g = 5$ volts) et la ligne de bit à 2 volts ($V_d = 2$ volts) pour la cellule sélectionnée à lire. La source est à la masse ($V_s = 0$). Ces valeurs sont données à titre indicatif.

Les autres lignes de mot sont laissées à 0. Les autres lignes de bit également.

La lecture consiste à mesurer le courant sur la ligne de bit. Ce courant doit exister lorsque la cellule n'est pas programmée mais pas si elle est programmée. Il faut donc que la tension sur la grille flottante dépasse la tension de seuil VT1 du transistor lorsqu'il n'est pas programmé et reste au dessous lorsqu'il est programmé. Et il faut d'autre part que les cellules 'non sélectionnées, soit parce que leur ligne de mot est à la masse soit parce que leur ligne de bit est à la masse, aient leur grille flottante à une tension inférieure à VT1.

3.a./ cellule sélectionnée

     $V_d = 2$ v      $V_s = 0$      $V_g = 5$ v

     D'où $V_f = 2,25$ v pour une cellule non programmée

     ou $V_f = 2,25$ v - Q = 0,75 v pour une cellule programmée.

     $V_f$ est supérieure à VT1 (2 volts) pour une cellule non programmée, un courant circule. Mais $V_f$ est inférieure à VT1 pour une cellule programmée; aucun courant ne circule. On peut donc lire l'état de la cellule.

3.b./ cellule totalement désélectionnée

     Ce sont les cellules reliées à des lignes de bit à la masse et reliées simultanément à des lignes de mot à la masse.

     $V_d = 0$      $V_s = 0$      $V_g = 0$

     D'où $V_f = 0$ pour une cellule non programmée

     ou $V_f = -1,5$ v pour une cellule programmée

aucun courant ne peut passer quel que soit l'état de la cellule.

3.c./ cellule désélectionnée par la grille

La ligne de mot, donc la grille de commande, est mise à la masse, mais le drain est à 2 volts

$$Vd = 2 v \qquad Vs = 0 \qquad Vg = 0$$

D'où $Vf = 1 v$, inférieur à VT1 pour une cellule non programmée et a fortiori inférieur pour une cellule programmée; aucun courant ne peut passer quel que soit l'état de la cellule.

3.d./ cellule désélectionnée par le drain

La ligne de bit, donc le drain, est mis à la masse; la ligne de mot est à 5 volts.

$$Vd = 0 \qquad Vs = 0 \qquad Vg = 5 v$$

D'où $Vf = 1,25$ volt, inférieur à VT1 pour une cellule non programmée et a fortiori inférieur pour une cellule programmée; aucun courant ne peut passer quel que soit l'état de la cellule.

On voit donc qu'on peut lire individuellement l'état programmé ou non de chaque cellule sans perturbation sur les autres cellules ou en provenance des autres.

La conclusion de ces calculs est qu'il est possible de trouver des conditions de potentiel permettant de programmer ou lire individuellement les cellules dans une organisation matricielle simple, sans rajouter un transistor de sélection pour chaque transistor à grille flottante. Et ceci est possible grâce à l'existence d'un fort couplage capacitif entre drain et grille flottante.

Bien entendu, il n'est pas possible ici de donner toutes les valeurs de couplages capacitifs et de potentiels qui conviennent. Elles dépendent notamment des conditions d'injection ou d'extraction d'électrons à travers la couche isolante 20.

Mais on aura compris d'après ce qui précède comment chaque potentiel de source, drain, grille, influe sur le potentiel de la grille flottante et comment on peut déterminer par conséquent les conditions de sélection ou de désélection, soit en programmation, soit en effacement, soit en lecture.

D'une manière très globale on peut dire que des conditions de fonctionnement sont possibles dès lors que le couplage drain-grille flottante est assez élevé devant le couplage source-grille flottante. Le couplage grille de commande/grille flottante étant proportionnellement réduit par rapport à ce qu'il est dans les EPROM ou EEPROM classiques.

Pour la réalisation pratique d'une telle cellule de mémoire, on pourra utiliser une technologie classique à deux niveaux de silicium poly-cristallin.

La grille flottante est réalisée par le premier niveau de silicium poly-cristallin, sur une couche isolante d'une centaine de nanomètres d'épaisseur. Puis elle est recouverte d'une couche isolante de quelques centaines de nanomètres d'épaisseur. Le deuxième niveau de silicium poly-cristallin est déposé et sert à constituer d'une part la grille de commande et d'autre part une portion de couche conductrice reliée au drain.

Un exemple de réalisation pratique est représenté à la figure 2, avec la topographie de la cellule vue de dessus représentée à la figure 3.

Chaque transistor est réalisé dans une zone active d'un substrat de silicium de type P. La zone active est délimitée par de l'oxyde de silicium épais 28 formé par oxydation localisée du substrat.

Les sources de tous les transistors du réseau matriciel ou d'un secteur de ce réseau sont toutes reliées par des lignes de source 30, formées entre des zones d'oxyde de silicium épais 28. Ces lignes sont des diffusions profondes de type de conductivité opposé à celui du substrat. Dans cet exemple, les lignes de source s'étendent horizontalement sur la figure 3, parallèlement aux lignes de mot de la mémoire.

Les sources proprement dites (10) des transistors sont réalisées pour chaque transistor par une extension locale de la ligne de source (extension vers le bas sur la figure 3). Les sources 10 sont réalisées par des implantations d'impuretés de type N, moins profondes que les diffusions 30; ces implantations sont réalisées après formation des grilles des transistors de manière que leurs bords soient auto-alignées avec les bords de la grille flottante.

Les drains 12 peuvent aussi être constitués en deux parties : une diffusion profonde 13 et une implantation moins profonde auto-alignée avec la grille flottante. La partie plus profonde peut être utilisée notamment pour recevoir un contact (non représenté) avec une ligne de bit reliant les drains de tous les transistors d'une même colonne. Cette ligne s'étendrait verticalement sur la figure 3.

La grille flottante est un rectangle 18 sur la figure 3; c'est une portion d'une couche de silicium polycristallin d'un premier niveau; entre la source 10 et le drain 12, sous la grille flottante, s'étend le canal 16 de type P du transistor. Latéralement, ce canal est délimité par de l'oxyde épais 28 sur lequel remontent les bords des grilles (d'une manière non visible sur la coupe de la figure 2 car la coupe s'étend longitudinalement, sur une ligne verticale de la figure 3).

La ligne de mot est une ligne de silicium polycristallin 32 (deuxième niveau) qui court aussi horizontalement d'un transistor à un autre et qui passe au dessus d'une partie de la grille flottante pour constituer à cet endroit la grille de commande 22 du transistor.

A côté de cette grille de commande et recouvrant également une partie de la grille flottante, il y a une autre partie 26 du deuxième niveau de silicium polycristallin. C'est elle qui sert à augmenter fortement le couplage capacitif entre drain et grille flottante. Pour cela elle est reliée au drain. Le couplage capacitif total résulte de l'addition du couplage habituel direct entre drain et grille flottante et du couplage supplémentaire lié à la partie 26. Au contraire, du côté de la source, il n'y a pas de moyen spécifique pour augmenter le couplage; il n'y a que le couplage direct habituel entre la source et la grille flottante, résultant de la nécessité d'avoir la source très près de la grille flottante.

La grille flottante 18 est séparée du canal 16 par une couche 20 d'oxyde de silicium d'une centaine de nanomètres d'épaisseur. La grille de commande et la partie 26 sont séparées de la grille flottante par une couche 24 de quelques centaines de nanomètres d'oxyde de silicium.

Comme on le voit sur la figure, la partie 26 est reliée au drain en faisant le tour du drain proprement dit : la partie 26 a une forme de U. Le contact avec le drain est pris à un endroit qui n'est pas immédiatement juxtaposé avec la grille flottante. La raison de cette disposition vient de la technologie de réalisation du drain par implantation ionique auto-alignée avec la grille. Il ne faut pas que la portion 26 masque le drain lorsque le drain est implanté, c'est-à-dire après dépôt et gravure des deux niveaux de silicium poly-cristallin.

Le contact de la région 26 avec le drain peut se faire de plusieurs manières différentes; par exemple une métallisation peut venir en contact à la fois avec les deux: cela est possible en utilisant le contact entre la ligne de bit métallique non représenté et le drain. Ou alors, la portion de couche 26 peut être mise en contact direct avec le substrat et servir de source de dopant (car elle sera en principe dopée fortement de type N) pour le substrat et ainsi réaliser un contact à l'intérieur du substrat avec le drain qui sera immédiatement adjacent ; la diffusion dans le substrat à partir du contact 34 entre la couche 26 et le substrat permet alors de faire une continuité de dopage de type N entre la partie profonde (diffusée) et la partie peu profonde (implantée avec auto-alignement) de la zone de drain, et en plus ce contact relie électriquement la partie 26 au drain.

## Revendications

1. Mémoire en circuit intégré comportant au moins un transistor à grille flottante, ayant une source (10), un drain (12), une grille flottante (18) et une grille de commande (22), caractérisée en ce que la grille de commande recouvre partiellement la grille flottante, et en ce qu'une partie de la grille flottante, non recouverte par la grille de commande, est recouverte par une couche semi-conductrice (26) reliée électriquement au drain afin d'établir un couplage capacitif élevé entre le drain et la grille flottante.

2. Mémoire selon la revendication 1, caractérisée en ce que le transistor présente un couplage capacitif entre drain et grille flottante environ deux fois supérieur au moins au couplage capacitif entre source et grille flottante.

3. Mémoire selon l'une des revendications 1 et 2, caractérisée en ce que le transistor comporte des moyens pour établir un couplage capacitif entre drain et grille flottante au moins égal au couplage capacitif entre grille de commande et grille flottante.

4. Mémoire selon la revendication 1, caractérisée en ce que la grille flottante est réalisée en un premier niveau de silicium poly-cristallin, et la grille de commande est réalisé en un second niveau de silicium poly-cristallin, une partie au moins de ladite couche semi-conductrice reliée au drain constituant également une partie de ce deuxième niveau.

5. Mémoire selon l'une des revendications 1 à 4, caractérisée en ce que les transistors sont organisés en réseau matriciel, les drains de tous les transistors d'une même colonne étant tous réunis, et les grilles de tous les transistors d'une même ligne étant réunis.

6. Mémoire selon la revendication 5, caractérisée en ce qu'elle comporte des moyens pour programmer les transistors à grille flottante en appliquant des potentiels sur la grille de commande et le drain, la source étant en haute impédance.

7. Mémoire selon l'une des revendications 1 à 6, caractérisée en ce que la couche semi-conductrice reliée électriquement au drain a la forme d'un U, une branche du U étant superposée à la grille flottante, la base du U s'étendant au delà du drain et au delà de la grille flottante, l'autre branche du U venant se connecter au drain.

## Patentansprüche

1. Speicher in integrierter Schaltung, umfassend wenigstens einen Transistor mit offenem Gate, aufweisend eine Source (10), einen Drain (12), ein offenes Gate (18) und ein Steuergate (22), dadurch **gekennzeichnet**, daß das Steuergate das offene Gate teilweise überdeckt und daß ein Teil des offenen Gates, der nicht durch das Steuergate überdeckt ist, durch eine halbleitende Schicht (26) überdeckt ist, die mit dem Drain elektrisch verbunden ist, um zwischen dem Drain und dem offenen Gate eine hohe kapazitive Kopplung vorzusehen.

2. Speicher nach Anspruch 1, dadurch **gekennzeichnet**, daß der Transistor zwischen dem Drain und dem offenen Gate eine kapazitive Kopplung wenigstens etwa zweimal höher als die kapazitive Kopplung zwischen Source und offenem Gate aufweist.

3. Speicher nach einem der Ansprüche 1 und 2, dadurch **gekennzeichnet**, daß der Transistor Mittel umfaßt, um zwischen Drain und offenem Gate eine kapazitive Kopplung wenigstens gleich der kapazitiven Kopplung zwischen Steuergate und offenem Gate vorzusehen.

4. Speicher nach Anspruch 1, dadurch **gekennzeichnet**, daß das offene Gate in einem ersten polykristallinen Siliciumniveau ausgeführt ist und das Steuergate in einem zweiten polykristallinen Siliciumniveau ausgeführt ist, wobei wenigstens ein Teil der mit dem Drain verbundenen halbleitenden Schicht ebenso einen Teil des zweiten Niveaus bildet.

5. Speicher nach einem der Ansprüche 1 bis 4, dadurch **gekennzeichnet**, daß die Transistoren im Matrixnetz organisiert sind, wobei die Drains sämtlicher Transistoren einer selben Spalte sämtlich verbunden sind und die Gates sämtlicher Transistoren einer selben Zeile verbunden sind.

6. Speicher nach Anspruch 5, dadurch **gekennzeichnet**, daß er Mittel zum Programmieren der Transistoren mit offenem Gate umfaßt, indem Potentiale auf das Steuergate und den Drain gegeben werden, wobei die Source mit hoher Impedanz ist.

7. Speicher nach einem der Ansprüche 1 bis 6, dadurch **gekennzeichnet**, daß die elektrisch mit dem Drain verbundene halbleitende Schicht die Form eines U aufweist, wobei ein Schenkel des U über dem offenen Gate liegt, wobei sich die Basis des U auf der anderen Seite des Drains und auf der anderen Seite des offenen Gates erstreckt, wobei der andere Schenkel des U in Verbindung mit dem Drain gelangt.

## Claims

1. Integrated-circuit memory including at least one floating-gate transistor, having a source (10), a drain (12), a floating gate (18) and a control gate (22), characterised in that the control gate partially covers the floating gate, and in that part of the floating gate which is not covered by the control gate is covered with a semiconducting layer (26) electrically connected to the drain in order to establish a high capacitive coupling between the drain and the floating gate.

2. Memory according to Claim 1, characterised in that the transistor has a capacitive coupling between the drain and floating gate at least approximately twice the capacitive coupling between the source and floating gate.

3. Memory according to one of Claims 1 and 2, characterised in that the transistor includes means for establishing a capacitive coupling between the drain and floating gate at least equal to the capacitive coupling between the control gate and floating gate.

4. Memory according to Claim 1, characterised in that the floating gate is made from a first level of polycrystalline silicon and the control gate is made from a second level of polycrystalline silicon, at least part of the said semiconducting layer connected to the drain also constituting part of this second level.

5. Memory according to one of Claims 1 to 4, characterised in that the transistors are organised in a matrix network, the drains of all the transistors in any one column all being connected together, and the gates of all the transistors in any one row being connected together.

6. Memory according to Claim 5, characterised in that it includes means for programming the floating-gate transistors by applying potentials to the control gate and drain, the source being at a high impedance.

7. Memory according to one of Claims 1 to 6, characterised in that the semiconducting layer electrically connected to the drain is in a U-shape, one leg of the U being superimposed on the floating gate, the base of the U extending beyond the drain and beyond the floating gate, the other leg of the U being connected to the drain.

# FIG_1

# FIG_2

# FIG_3

10